# EUROPÄISCHE PATENTSCHRIFT

(11) **EP 0 402 894 B1**
(45) Veröffentlichungstag und Bekanntmachung des Hinweises auf die Patenterteilung: **26.07.1995**
(21) Anmeldenummer: 90111192.2
(22) Anmeldetag: 13.06.1990
(51) Int. Cl.: G03F 7/027

(54) **Photoresist**
Photoresist
Photoréserve

(30) Priorität: 16.06.1989 CH 2254/89
(43) Veröffentlichungstag der Anmeldung: 19.12.1990
(73) Patentinhaber: CIBA-GEIGY AG, 4002 Basel (CH)
(72) Erfinder: Kurt, Meier, Dr., CH-4106 Therwil (CH); Lunn, Robert James, Dr., Bar Hill, Cambridge CB3 8TJ (GB); Kroehnke, Christoph, Dr., D-7800 Freiburg/Munzingen (DE); Eugster, Giuliano, CH-4452 Itingen (CH)
(74) Vertreter: Zumstein, Fritz, Dr.

(56) Entgegenhaltungen:
- EP-A- 0 115 354
- PATENT ABSTRACTS OF JAPAN vol. 3, no. 157 (C-68) 22. Dezember 1979 & JP-A-54 132 633

## Beschreibung

Die vorliegende Erfindung betrifft neue entwickelbare Photoresistzusammensetzungen, die sich insbesondere als Lötstoppresists eignen.

Lösungsmittelfreie photohärtbare Zusammensetzungen auf Basis radikalisch polymerisierbarer Verbindungen und blockierter Isocyanate sind aus der JP-A-54-132,633 bekannt. Diese Zusammensetzungen werden strukturiert auf ein Substrat aufgebracht und anschliessend mit UV-Strahlung gehärtet. Sie lassen sich unter anderem als Lötstoppresists verwenden. Entwickelbare Systeme sind dort nicht beschrieben. Strukturiert aufgebrachte Resists besitzen im allgemeinen eine geringere Auflösung als entwickelbare Resists.

Aus der EP-A-115,354 sind Photoresists auf (Meth)acrylatbasis bekannt, die einen Aldehydkondensationsharz-Vorläufer als Vernetzungsmittel und ein ausgewähltes säuregruppenhaltiges Bindemittel enthalten. Diese Zusammensetzungen sind bei Raumtemperatur lagerfähig und sie lassen sich andererseits bei für solche Resists relativ niedrigen Temperaturen aushärten.

Photoresists werden im allgemeinen durch Laminieren oder aus der Lösung auf ein Substrat aufgebracht. Bei diesen Verfahrensschritten wird der Resist üblicherweise erwärmt, beispielsweise während des Laminiervorganges oder während des Abdampfens des Lösungsmittels nach dem Aufbringen aus der Lösung. Dabei läuft in der Regel bereits vor der Photostrukturierung eine teilweise Vernetzung ab. Dies kann zu einer Verschlechterung der Bildqualität führen, da auch in den nichtbelichteten Bereichen eine teilweise Vernetzung eingetreten ist. Ein Photoresist sollte also durch diese Wärmebehandlung möglichst wenig chemisch verändert werden. Auf der anderen Seite soll ein Photoresist nach dem Aufbringen und bildmässigen Belichten rasch und bei möglichst niedrigen Temperaturen ausgehärtet werden, um eine hohe Durchsatzgeschwindigkeit bei den verwendeten Apparaturen bei gleichzeitiger Einsparung von Energiekosten zu erzielen.

Es wurde nun gefunden, dass man die bekannten photohärtbaren Zusammensetzungen durch die Verwendung von ausgewählten Bindemitteln und Vernetzern so modifzieren kann, so dass ein lagerstabiler und einfach aus Lösung zu verarbeitender, entwickelbarer Photoresist erhalten wird, mit dem Abbildungen hoher Auflösung erzielt werden können und der sich nach der thermischen Härtung durch geringe Sprödigkeit sowie durch hohe Temperatur- und Chemikalienbeständigkeit auszeichnet.

Im Vergleich mit Lötstoppresists, die mit Hexamethoxymethylmelamin gehärtet werden, zeichnen sich die erfindungsgemässen Resists überraschenderweise durch eine höhere Latenz aus. Damit lassen sich Beschichtungen aus diesen Resists auch aus höher siedenden Lösungsmitteln aufbringen und anschliessend kurzzeitig bei Temperaturen von über 100°C trocknen. Somit vergrössert sich die Anzahl der zur Beschichtung zur Verfügung stehenden Lösungsmittel; insbesondere können nichthalogenierte Lösungsmittel für die Beschichtung eingesetzt werden. Für gewisse Beschichtungsverfahren müssen höher siedende Lösungsmittel angewendet werden, beispielsweise bei der Beschichtung mittels Vorhangguss oder mittels Siebdruck.

Die vorliegende Erfindung betrifft eine photohärtbare und lösungsmittelentwickelbare Zusammensetzung enthaltend
a) ein photopolymerisierbares Acrylat oder Methacrylat,
b) einen Photoinitiator für Komponente a),
c) ein polymeres organisches Bindemittel enthaltend freie Carboxylgruppen, welches eine Säurezahl von mindestens 60 aufweist,
d) als Vernetzungsmittel ein blockiertes Polyisocyanat, das eine Aufspalttemperatur von mindestens 100°C besitzt, und
e) ein inertes Lösungsmittel in einer solchen Menge, dass die photohärtbare Zusammensetzung giessfähig ist.

Die Komponenten a) bis e) können jeweils einzeln vorliegen. Man kann aber auch Gemische mehrerer dieser Komponenten einsetzen, beispielsweise Gemische mehrerer (Meth)acrylate.

Bei Komponente a) kann es sich um monomere oder um oligomere (Meth)acrylate handeln, sofern diese photopolymerisierbar sind, also insbesondere durch UV- und/oder VIS-Strahlung in vernetzte und unlösliche Produkte übergeführt werden können.

Dabei handelt es sich insbesondere um Verbindungen enthaltend zwei oder mehrere funktionelle Gruppen der Formel I 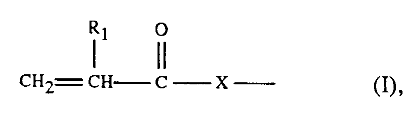
worin R₁ Wasserstoff oder Methyl bedeutet, X -NR₂- und insbesondere -O- ist und R₂ Wasserstoff oder C₁-C₈ Alkyl bedeutet.

Verbindungen enthaltend Gruppen der Formel I sind im allgemeinen Ester oder Amide auf Basis von aliphatischen, cycloaliphatischen, aromatischen oder araliphatischen mehrwertigen Alkoholen oder Aminen.

Monomere oder oligomere Komponenten a) sind dem Fachmann auf dem Gebiet der Photoresists an sich bekannt und beispielsweise in der EP-A-115,354 beschrieben.

Bevorzugte Komponenten a) sind Verbindungen der Formel II

A-R₃-(A)ₙ (II),

worin A ein Rest der Formel I ist, n 2,3 oder 4 bedeutet und R₃ der Rest eines aliphatischen oder cycloaliphatischen n-wertigen Alkohols nach dem Entfernen der funktionellen Gruppen ist.

Beispiele für Reste R₂ sind Ethyl, n-Propyl, Isopropyl, n-Butyl, sek.Butyl, n-Pentyl, n-Hexyl, n-Heptyl, n-Octyl und insbesondere Methyl.

Beispiele für dem Rest R₃ zugrundeliegende aliphatische Alkohole sind Alkylendiole, wie 1,2-Ethandiol, 1,2-Propandiol, 1,3-Propandiol, 1,4-Butandiol, 1,5-Pentandiol, 1,6-Hexandiol, 1,8-Octandiol, 1,10-Decandiol, 1,12-Dodecandiol, Di- oder Triethylenglykol, Tripropylenglykol, 2,2-Dimethylolpropan; oder dreiwertige aliphatische Alkohole, wie Trimethylolethan, Trimethylolpropan, polyoxyethyliertes Trimethylolpropan oder Glycerin; oder vierwertige Alkohole, wie Pentaerythrit.

Beispiele für dem Rest R₃ zugrundeliegende cycloaliphatische Alkohole sind 1,3- oder 1,4-Cyclohexandiol oder 1,4-Dimethylolcyclohexan.

Besonders bevorzugte Komponenten a) enthalten neben den Acrylat- und/oder den Methacrylatgruppen noch zusätzliche funktionelle gegenüber Isocyanaten reaktive Reste, beispielsweise Aminogruppen oder insbesondere freie Carboxylgruppen oder Alkoholgruppen. Beispiele dafür sind (Meth)acrylsäureester der oben erwähnten Polyalkohole, bei denen nur ein Teil der alkoholischen Reste verestert ist.

Als Photoinitatoren b) lassen sich alle an sich üblichen Initiatoren der radikalischen Polymerisation einsetzen.

Beispiele für geeignete Photoinitiatoren b) sind aromatische Carbonylverbindungen, wie beispielsweise Benzoin, Benzoinalkylether, wie der Isopropyl- oder der n-Butylether, α-substituierte Acetophenone, insbesondere Benzilketale, wie Benzil-dimethylketal, oder insbesondere α-halogensubstituierte Acetophenone, wie Trichlormethyl-p-tert.butylphenyl-keton, oder insbesondere α-amino-substituierte Acetophenone, wie Dimethylaminomethyl-phenyl-keton oder Morpholino-methyl-phenyl-keton, oder insbesondere Dialkoxyacetophenone, wie Diethoxyacetophenon, oder insbesondere α-Hydroxyacetophenone, wie 1-Hydroxycyclohexylphenyl-keton; oder Benzophenone, wie Benzophenon selbst oder Bis-(4-dimethylamino)-benzophenon; oder Metalloceninitiatoren, wie Titanoceninitiatoren, beispielsweise Bis-(π-methylcyclopentadienyl)-bis-(σ-pentafluorophenyl)-titan-IV; oder ein Stannan in Kombination mit einem photoreduzierbaren Farbstoff, beispielsweise Trimethyl-benzyl-stannan in Kombination mit Methylenblau oder Bengalrosa; oder ein Chinon oder ein Thioxanthon in Kombination mit einem Amin, das an einem α-C-Atom mindestens ein Wasserstoffatom aufweist, wie Anthrachinon, Benzochinon oder Thioxanthon in Kombination mit Bis-(4-Dimethylamino)-benzophenon oder Triethanolamin; oder ein Thioxanthon, beispielsweise ein alkyl- oder halogen-substituiertes Thioxanthon, wie z.B. 2-Isopropylthioxanthon oder 2-Chlorthioxanthon; oder Acylphosphinoxide.

Als Komponente c) lassen sich unterschiedliche organische polymere Bindemittel enthaltend freie Carboxylgruppen verwenden, sofern diese eine Säurezahl von mindestens 60 aufweisen und somit als solche in einem Entwickler löslich sind. Dazu besitzt das Bindemittel in der Regel seitenständige freie Carboxylgruppen. Solche Bindemittel leiten sich im allgemeinen von polymerisierbaren ethylenisch ungesättigten Monomeren mit freien Carboxylgruppen ab. Beispiele für solche Monomere sind Acrylsäure, Methacrylsäure, Maleinsäure oder Itaconsäure. Diese Bindemittel enthalten in der Regel noch weitere Comonomere ohne saure Gruppen, beispielsweise die Ester oder Amide der oben erwähnten Säuren oder 1-Alkene oder Styrol.

Ebenfalls können die Bindemittel freie Carboxylgruppen und Acrylat- bzw. Methacrylatgruppen im gleichen Molekül enthalten. Hierzu gehören beispielsweise Reaktionsprodukte eines Epoxy(meth)acrylats mit Carbonsäureanhydriden. Unter Epoxy(meth)acrylaten versteht man Umsetzungsprodukte von Epoxyverbindungen, vorzugsweise auf der Basis von Novolaken oder unmodifiziertem oder modifiziertem Bisphenol A, mit Acryl- oder Methacrylsäure. Diese Epoxy(meth)acrylate werden dann mit Carbonsäureanhydriden, wie beispielsweise Tetrahydrophthalsäureanhydrid, Hexahydrophthalsäureanhydrid, Pyromellitsäure-dianhydrid oder Benzophenon-tetra-carbonsäure-dianhydrid umgesetzt. Solche polymeren Bindemittel sind in EP-A-292,219 und GB-A-2,175,908 beschrieben.

Weitere Bindemittel mit freien Carboxylgruppen und Acrylat- bzw. Methacrylatgruppen im gleichen Molekül sind beispielsweise Umsetzungsprodukte von Styrol-Maleinsäureanhydrid-Copolymeren mit Hydroxy(meth)acrylaten, wie zum Beispiel 2-Hydroxyethyl(meth)acrylat oder 3-Hydroxypropyl(meth)acrylat. Polymere Bindemittel dieses Typs sind in EP-A-287,019 beschreiben.

Das polymere Bindemittel c) weist im allgemeinen ein Molekulargewicht von etwa 2000 bis 500000 (Zahlenmittel) auf.

Bevorzugte Bindemittel c) sind als solche in alkalisch-wässrigen Lösungsmitteln löslich. Mit solchen Bindemitteln lassen sich wässrig entwickelbare Photoresists formulieren. Solche Resists sind besonders bevorzugt.

Zu diesen besonders bevorzugten Bindemitteln c) zählen Homopolymere auf der Basis von Acrylsäure, Methacrylsäure, Maleinsäure oder Itaconsäure, Copolymere auf der Basis von Acrylsäure, Methacrylsäure, Maleinsäure oder Itaconsäure und Styrol oder Estern dieser Säuren, insbesondere deren Alkylestern.

Die erfindungsgemäss zu verwendenden Bindemittel sind zum Teil kommerziell erhältlich. Beispiele dafür sind Polymere des Typs Carboset® und Scripset®. Weitere geeignete polymere Bindemittel c) sind in der EP-A-115,354 beschrieben.

Als Vernetzungsmittel d) wird ein blockiertes Polyisocyanat oder eine Mischung solcher Polyisocyanate verwendet, das eine Aufspalttemperatur von mindestens 100°C besitzt. Darunter versteht man im Rahmen dieser Beschreibung ein blockiertes Polyisocyanat, bei dem mindestens die Hälfte der Isocyanatgruppen bei einer Temperatur von 100°C durch Deblockierung wieder freigesetzt ist und für eine Reaktion mit den gegenüber Isocyanatgruppen reaktiven funktionellen Gruppen der anderen Komponenten des Photoresists zur Verfügung steht.

Bei dem der blockierten Komponente d) zugrundeliegenden Polyisocyanat kann es sich um eine beliebige aliphatische, cycloaliphatische, aromatische oder araliphatische Verbindungen mit wenigstens zwei, vorzugsweise zwei bis vier Isocyanatgruppen handeln, die gegebenenfalls weitere gegenüber Isocyanatgruppen inerte Substituenten, wie Alkyl- oder Alkoxygruppen oder Halogenatome aufweisen.

Dazu zählen beispielsweise die folgenden Verbindungen: 2,4-Diisocyanatotoluol sowie dessen technische Gemische mit 2,6-Diisocyanatotoluol, 2,6-Diisocyanatotoluol, 1,5-Diisocyanatonaphthalin, 4,4′-Diisocyanatodiphenylmethan sowie technische Gemische verschiedener Diisocyanatodiphenylmethane (beispielsweise der 4,4′- und der 2,4′-Isomeren), Diisocyanato-m-xylylen, N,N′-Di-(4-methyl-3-isocyanatophenyl)-harnstoff, 1,6-Diisocyanatohexan, 3,5,5-Trimethyl-1-isocyanatomethylcyclohexan (Isophorondiisocyanat), Trimethyl-1,6-diisocyanatohexan, 1-Methyl-2,4-diisocyanatocyclohexan, Dimeryldiisocyanat, Triisocyanatotriphenylmethan und 4,4′-Diisocyanatodicyclohexylmethan.

Diese Polyisocyanate können mit unterschiedlichen Resten verkappt sein. Als Verkappungskomponenten eignen sich beispielsweise β-Dicarbonylverbindungen, wie Malonester, Acetoessigester oder 2,4-Pentandion, oder Hydroxamsäureester, Triazole, Imidazole, Imidazolide, Tetrahydropyrimidine, Lactame, Oxime, Hydroxyimide, wie N-Succinimid, oder Phenole bzw. Thiophenole.

Als Komponente d) können auch urethanisierte, carbodiimidisierte oder di- oder trimerisierte Polyisocyanate oder andere unterhalb von 100°C inaktive Formen von Polyisocyanaten eingesetzt werden, sofern deren Aufspalttemperatur oberhalb von 100°C liegt. Beispiele dafür sind urethanisiertes 4,4′-Diisocyanatodiphenylmethan, carbodiimidisiertes 4,4′-Diisocyanatodiphenylmethan, das Urethdion des 2,4-Diisocyanatotoluols, das Trimerisat aus Diisocyanatotoluol, N,N′,N˝-Tri-(6-isocyanatohexyl)-biuret, 2,2,4-trimeres Isophorondiisocyanat sowie trimeres Hexandiisocyanat.

Bevorzugte Komponenten d) besitzen eine Aufspalttemperatur zwischen 100 und 160°C. Besonders bevorzugte Komponenten d) sind mit Oximen blockierte Polyisocyanate, insbesondere Diisocyanate.

Das inerte Lösungsmittel e) muss die Komponenten a) bis e) lösen und wird in einer solchen Menge eingesetzt, dass die photohärtbare Zusammensetzung giessfähig ist. Das Lösungsmittel soll die Lagerstabilität der Mischung nicht negativ beeinflussen und muss daher gegenüber den Mischungsbestandteilen weitgehend inert sein. Ferner sollte es einen möglichst niedrigen Verdampfungspunkt besitzen, um nach dem Auftrag des Photoresists auf das Substrat leicht entfernt werden zu können. Beispiele für geeignete Lösungsmittel sind Kohlenwasserstoffe, wie aliphatische Kohlenwasserstoffe, beispielsweise Trichlorethan; oder aromatische Kohlenwasserstoffe, wie Dichlorbenzol; oder Ester, wie Methylglykolacetat, Methoxypropylacetat oder 3-Ethoxy-propionsäureethylester; oder Ketone, wie Diisopropylketon oder Cyclohexanon; oder Alkohole, wie Methylglykol oder Methoxypropanol; oder Lactone, wie γ-Butyrolacton; oder Lactame, wie N-Methylpyrrolidon.

Die Menge der einzelnen Komponenten der erfindungsgemässen Zusammensetzungen kann je nach Natur und Anwendungsgebiet des strahlungsempfindlichen Gemisches in weiten Grenzen variiert werden. Die folgenden Gewichtsangaben beziehen sich jeweils auf die Gesamtmenge an Komponenten a) bis e), sofern nichts anderes angegeben ist.

Die Menge des polymerisierbaren Monomeren oder Monomergemisches a) beträgt im allgemeinen 1-50 Gew.%, vorzugsweise 10-30 Gew.%.

Die Menge der Initiatorkomponente b) beträgt im allgemeinen 1-30 Gew.%, insbesondere 5-20 Gew.%, bezogen auf die Gewichtsmenge an Komponente a).

Die Menge des Bindemittels c) beträgt im allgemeinen 10-70 Gew.%, vorzugweise 10-50 Gew.%.

Die Menge des Vernetzers d) beträgt im allgemeinen 2-20 Gew.%, vorzugsweise 5-15 Gew.%.

Die Menge des Lösungsmittels e) beträgt im allgemeinen 5-80 Gew.%, insbesondere 15-60 Gew.%.

Die erfindungsgemässen Zusammensetzungen können weitere an sich übliche Zusatzstoffe enthalten, wie z.B. Stabilisatoren, Sensibilisatoren, Pigmente, Farbstoffe, Füllstoffe, Haftvermittler, Verlaufsmittel, Netzmittel und Weichmacher. Die Menge solcher Zusatzstoffe beträgt üblicherweise 0,01-50 Gew.%, bezogen auf die Gesamtzusammensetzung.

Die erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyolefine, Celluloseacetat oder Epoxidharze, insbesondere glasfaserverstärkte Epoxidharze, sowie für Metalle, wie Al, Cu, Ni, Fe, Zn, Mg oder Co, oder für Halbleitermaterialien, wie Si, GaAs oder Ge, oder für Isolatormaterialien, wie Si₃N₄ oder SiO₂, bei denen durch Belichten eine Abbildung oder eine Schutzschicht aufgebracht werden soll.

Die Erfindung betrifft auch ein Verfahren zur Herstellung von Reliefstrukturen umfassend die Schritte:
i) Aufbringen der erfindungsgemässen Zusammensetzung auf eine Substratoberfläche,
ii) Trocknen des beschichteten Substrates durch Verdampfen der wesentlichen Anteile des Lösungsmittels e), vorzugsweise durch Erhitzen des beschichteten Substrates, so dass das Lösungsmittel e) im wesentlichen entfernt wird und eine klebfreie Oberfläche entsteht,
iii) bildmässiges Bestrahlen der photoempfindlichen Schicht mit aktinischer Strahlung, so dass die bestrahlten Bereiche der Schicht photopolymerisieren und gegenüber den nicht bestrahlten Bereichen der Schicht weniger löslich werden,
iv) Entfernen der nicht bestrahlten Bereiche der Schicht durch Behandlung der Schicht mit einem Lösungsmittel für die erfindungsgemässe Zusammensetzung, vorzugsweise mit einem alkalisch-wässrigen Entwickler,
v) Erhitzen der entwickelten Schicht auf Temperaturen oberhalb der Aufspalttemperatur des verkappten Polyisocyanats d), um die bestrahlte Zusammensetzung durch und durch zu vernetzen.

Die Herstellung der beschichteten Substrate kann z.B. erfolgen, indem man eine Lösung oder Suspenion der erfindungsgemässen Zusammensetzung herstellt. Diese wird im allgemeinen mittels an sich bekannter Beschichtungsverfahren auf ein Substrat gleichförmig aufgebracht. Beispiele für Beschichtungsverfahren sind Schleudern, Tauchen, Rakelbeschichtung, Vorhanggiessverfahren, Aufpinseln, Aufsprühen und Reverse- Rollbeschichtung.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in dünnen Schichten aufgebracht werden können und sich durch eine gute Auflösung auszeichnen. Sie eignen sich bei entsprechend gewählter Strahlungsquelle und strahlungsempfindlicher Komponente für ein breites Spektrum von Anwendungsgebieten, wo die Erzeugung von strukturierten Bildern erwünscht ist.

Besonders vorteilhaft ist ihr Einsatz jedoch bei der Herstellung von Leiterplatten als photostrukturierbarer Lötstoppresist oder als Permanentresist. Diese Verwendungen sind ebenfalls Gegenstand der vorliegenden Erfindung.

Nach dem Beschichten wird das Lösungsmittel üblicherweise durch Trocknen entfernt und es resultiert eine amorphe Schicht des Resists auf dem Träger. Die Filmschichtdicken betragen nach dem Trocknen vorzugsweise 5-150 »m. Die Trocknung erfolgt üblicherweise bei erhöhten Temperaturen, die üblicherweise so gewählt werden, dass eine Deblockierung der Komponente d) im wesentlichen noch nicht stattfindet. Das Lösungsmittel kann auch durch Anlegen eines Vakuums entfernt werden.

Die strahlungsempfindliche Schicht wird anschliessend in an sich bekannter Weise einer Strahlung ausgesetzt, um die Komponente a) zu photopolymerisieren. Dies erfolgt im allgemeinen bildmässig. An den belichteten Stellen der Schicht tritt infolge der Photopolymerisation der Komponente a) eine Verringerung der Löslichkeit gegenüber den unbelichteten Stellen ein, so dass eine Differenzierung der Oberfläche möglich wird.

Die Belichtung der erfindungsgemässen Zusammensetzungen erfolgt mit aktinischer Strahlung. Dabei handelt es sich in der Regel um UV- und/oder VIS-Strahlung. Bevorzugt wird Strahlung im Bereich von ca. 220 - 450 nm. Zur Bestrahlung können alle an sich bekannten Strahlungsquellen eingesetzt werden, beispielsweise Quecksilberhochdrucklampen oder UV-/VIS-Laser. Die Verfahrensparameter, wie z.B. Bestrahlungsdauer und Abstand von Strahlungsquelle und lichtempfindlicher Schicht, werden im allgemeinen von der Art der strahlungsempfindlichen Zusammensetzung und von den gewünschten Eigenschaften des Ueberzugs abhängen und können vom Fachmann anhand von Routineversuchen eingestellt werden. Die bildmässige Belichtung kann durch eine Photomaske erfolgen oder durch direktes Schreiben eines Laserstrahls auf der lichtempfindlichen Schicht.

Nach der Belichtung erfolgt eine Entwicklungsstufe. Durch die Einwirkung eines Entwicklers werden die unbelichteten Stellen des Photoresists entfernt. Als Entwickler ist praktisch jedes Lösungsmittel für die unbelichtete Zusammensetzung geeignet, in welchem sich die bestrahlte und teilweise gehärtete Zusammensetzung nicht oder nur zum Teil löst.

Bevorzugt werden alkalisch-wässrige Lösungen als Entwickler. Dazu zählen insbesondere Lösungen von Alkalimetallcarbonaten, -hydroxiden, -silikaten und -phosphaten. Diese Lösungen können gegebenenfalls noch kleinere Mengen an Netzmitteln und/oder organischen Lösungsmitteln enthalten.

Besonders bevorzugt werden wässrige Lösungen von Alkalimetallcarbonaten, beispielsweise 1 %ige Natriumcarbonatlösung.

Die Entwicklung mit organischen Lösungmitteln ist ebenfalls möglich. In Frage kommen beispielsweise Ketone, wie Cyclohexanon, Aceton oder Methylethylketon, oder Alkohole, wie 2-Ethoxyethanol, Diacetonalkohol oder Diethylenglykolmonobutylether.

Nach der Belichtung und Entwicklung wird die Beschichtung einer thermischen Nachbehandlung unterworfen. Dazu wird die Schicht auf solche Temperaturen erhitzt, dass der Vernetzer d) deblockiert wird und die freiwerdenden Isocyanatgruppen mit den Carboxylgruppen des Bindemittels c) und gegebenenfalls mit weiteren gegenüber Isocyanatgruppen reaktiven Resten der Komponente a) reagieren. Die Temperatur bei diesem Schritt muss über der Aufspalttemperatur des verkappten Polyisocyanats liegen und wird in Abhängigkeit von der eingesetzten Komponente d) gewählt. In jedem Falle beträgt die Temperatur bei diesem Schritt mehr als 100°C, vorzugsweise 120-180°C.

### I. Synthese des Photoresistbinderpolymer

Beispiel 1: 54,51 g (0,1125 mol) des Reaktionsproduktes von Bisphenol-A-diglycidylether mit Acrylsäure werden in 131,7 g Dioxan gelöst. Bei 70 °C werden zu dieser Lösung 0,87 g Di-tertiär-butyl-para-kresol und 32,2 g (0,1 mol) Benzo-phenon-tetra-carbonsäure-dianhydrid zugegeben. Nachdem der Reaktionsinhalt siedet, werden noch 246 mg (2 mmol) 4-Dimethylamino-pyridin als Katalysator zugegeben. Nach 26 h Kochen unter Rückfluss werden 2,25 Aequivalente Säure pro kg Reaktionsprodukt gefunden und die Reaktion wird abgebrochen.

Beispiel 2: 54,51 g (0,1125 mol) des Reaktionsproduktes von Bisphenol-A-diglycidylether mit Acrylsäure werden in 114 g Dioxan gelöst. Bei 70 °C werden zu dieser Lösung 0,87 g Di-tertiär-butyl-para-kresol und 21,81 g (0,1 mol) Pyromellitsäure-dianhydrid zugegeben. Nachdem der Reaktionsinhalt siedet, werden noch 246 mg (2 mmol) 4-Dimethylamino-pyridin als Katalysator zugegeben. Nach 24 h Kochen unter Rückfluss werden 2,55 Aequivalente Säure pro kg Reaktionsprodukt gefunden und die Reaktion wird abgebrochen.

Beispiel 3: 87,7 g des Reaktionsproduktes eines avancierten Bisphenol-A-diglycidylethers (Erweichungspunkt 70-80 °C) mit Acrylsäure, 45,6 g Tetrahydrophthalsäureanhydrid und 0,12 g Hydrochinon werden bei Raumtemperatur in 180 ml Dioxan gelöst. Anschliessend werden 0,18 g 4-Dimethylamino-pyridin zugegeben und für 24 h am Rückfluss gekocht. Das Polymer wird aus Wasser ausgefällt und getrocknet. Die Ausbeute beträgt 100 %.

Beispiel 4: 230 g eines Epoxykresolnovolacks (Epoxidwert 4,35 eq./kg), 64,7 g Acrylsäure, 0,59 g Di-tertiär-butyl-para-kresol und 1,47 g Benzyldimethylamin werden in 300 g Ethylglykolacetat für 3,5 h auf 110 °C erhitzt. In dieser Zeit sinkt der Epoxidwert auf 0,3 eq./kg. Anschliessend werden 131,8 g Hexahydrophthalsäureanhydrid und 1.05 g 4-Dimethylamino-pyridin zugegeben und für weitere 24 h bei 110 °C gekocht. Es werden 3.2 Aequivalente Säure pro kg gefunden.

### II. Herstellung und Eigenschaften der Photoresists

Beispiel 5: Eine Lösung bestehend aus 9,2 g Scripset® 550 (teilweise verestertes Copolymeres auf Basis von Styrol und Maleinsäure der Fa. Monsanto), 7,9 g Scripset® 540 (teilweise verestertes Copolymeres auf Basis von Styrol und Maleinsäure der Fa. Monsanto), 3,0 g Tetraethylenglykoldimethacrylat, 2,0 g Trimethylolpropantriacrylat, 8,4 g Talkum Ultramix (Cyprus), 0,21 g Farbstoff (Orasolblau GN; CIBA-GEIGY), 3,2g Pentaerythritoltriacrylat, 1,5 g 2-Methyl-1-[4-(methylthio)phenyl] -2-morpholinopropan-1-on, 4,8 g O,O′-[Methylen-bis-(1,4-phenyleniminocarbonyl)]-dioxim-butan-2-on, und 0,2 g 4,4′-Bis-(diethylamino)-benzophenon in 53,2 g Cyclohexanon wird mit einem Rakelbeschichtungsgerät auf eine Leiterplatte aufgebracht. Anschliessend wird der Film 5 Minuten bei 100 °C getrocknet. Die so erhaltene Schicht wird durch eine Maske während 15 Sekunden mit einer Quecksilberhochdrucklampe belichtet (Abstand vom Probentisch: 50 cm). Die belichtete Probe wird in einer 1 %igen wässrigen Natriumcarbonatlösung entwickelt und während einer Stunde bei 140 °C gehärtet. Man erhält eine Schicht mit guter Lötbadbeständigkeit (1 Minute bei 270 °C) und einer Methylenchloridbeständigkeit von grösser als 30 Minuten.

Beispiel 6: Eine Lösung bestehend aus 45,6 g Lösung aus Beispiel 1 (18,3 g Feststoff), 8,8 g Gemisch von verschiedenen Acrylsäureestern (3,2 g Tetraethylenglykoldimethacrylat, 2,2 g Trimethylolpropantriacrylat und 3,4 g Pentaerythritoltriacrylat), 9 g Talkum Ultramix (Cyprus), 0,21 g Farbstoff (Orasolblau GN; CIBA-GEIGY), 1,6 g 2-Methyl-1-[4-(methylthio)phenyl]-2-morpholino-propan-1-on, 4,8 g O,O′-[Methylen-bis-(1,4-phenyleniminocarbonyl)]-dioxim-butan-2-on, 0,21 g 4,4′-Bis-(diethylamino)-benzophenon und 0,2 g FC-430 (3M-Company) in 27,5 g Cyclohexanon wird mit einem Rakelbeschichtungsgerät auf eine Leiterplatte aufgebracht. Der Film wird für 30 Minuten bei 80 °C getrocknet. Es resultiert eine Schichtdicke von ungefähr 40 »m. Die so erhaltene Schicht wird durch eine Maske für 30 Sekunden mit einer Quecksilberhochdrucklampe belichtet (Abstand vom Probentisch 50 cm). Die belichtete Probe wird mit einer 1 %igen Natriumcarbonatlösung in einem Sprühentwickler (Convac, Sprühdruck 3-4 bar) für 75 Sekunden entwickelt. Die belichtete und entwickelte Platte hatte einen Gitterschnitt von Gt0 (DIN 53151) und die Bleistifthärte beträgt HB. Belichtete und entwickelte Platten werden bei 140 °C während einer Stunde zusätzlich gehärtet. Der Gitterschnittest ergibt Gt0, Bleistifthärte 5H, Beständigkeit in Methylenchlorid >1 h und Lötbadbeständigkeit >1 Minute.

Beispiel 7: Eine Lösung bestehend aus 45,7 g Lösung aus Beispiel 2 (18,3 g Feststoff), 8,8 g Gemisch von verschiedenen Acrylsäureestern (3,2 g Tetraethylenglykoldimethacrylat, 2,2 g Trimethylolpropantriacrylat und 3,4 g Pentaerythritoltriacrylat), 9 g Talkum Ultramix (Cyprus), 0,21 g Farbstoff (Orasolblau GN; CIBA-GEIGY), 1,6 g 2-Methyl-1-[4-(methylthio)phenyl]-2-morpholino-propan-1-on, 4,8 g O,O′-[Methylen-bis-(1,4-phenyleniminocarbonyl)]-dioxim-butan-2-on, 0,21 g 4,4′-Bis-(diethylamino)-benzophenon und 0,2 g FC-430 (3M-Company) in 27,4g Cyclohexanon wird mit einem Rakelbeschichtungsgerät auf eine Leiterplatte aufgebracht. Der Film wird für 30 Minuten bei 80 °C getrocknet. Es resultiert eine Schichtdicke von ungefähr 40 »m. Die so erhaltene Schicht wird durch eine Maske für 60 Sekunden mit einer Quecksilberhochdrucklampe belichtet (Abstand vom Probentisch 50 cm). Die belichtete Probe wird mit einer 1 %igen Natriumcarbonatlösung in einem Sprühentwickler (Convac, Sprühdruck 3-4 bar) für 45 Sekunden entwickelt. Die belichtete und entwickelte Platte hatte einen Gitterschnitt von Gt0 (DIN 53151) und die Bleistifthärte beträgt HB. Belichtete und entwickelte Platten werden bei 140 °C während einer Stunde zusätzlich gehärtet. Der Gitterschnittest ergibt Gt1, Bleistifthärte 7H, Beständigkeit in Methylenchlorid >1 h und Lötbadbeständigkeit >1 Minute.

Beispiel 8: Eine Lösung bestehend aus 18.3 g Binderpolymer aus Beispiel 3, 8,8 g Gemisch von verschiedenen Acrylsäureestern (3,2 g Tetraethylenglykoldimethacrylat, 2,2 g Trimethylolpropantriacrylat und 3,4 g Pentaerythritoltriacrylat), 9 g Talkum Ultramix, 0,21 g Farbstoff (Orasolblau GN; CIBA-GEIGY), 1,6 g 2-Methyl-1-[4-(methylthio)phenyl]-2-morpholino-propan-1-on, 4,8 g O,O′-[Methylen-bis-(1,4-phenyleniminocarbonyl)]-dioxim-butan-2-on, 0,21 g 4,4′-Bis-(diethylamino)-benzophenon und 0,2 g FC-430 (3M-Company) in 27,5 g Cyclohexanon wird mit einem Rakelbeschichtungsgerät auf eine Leiterplatte aufgebracht. Der Film wird für 15 Minuten bei 80 °C getrocknet. Es resultiert eine Schichtdicke von ungefähr 40 »m. Die so erhaltene Schicht wird durch eine Maske für 15 Sekunden mit einer Quecksilberhochdrucklampe belichtet (Abstand vom Probentisch 50 cm). Die belichtete Probe wird mit einer 1 %igen Natriumcarbonatlösung entwickelt. Die belichtete und entwickelte Platte hatte einen Gitterschnitt von Gt0 (DIN 53151) und die Bleistifthärte beträgt HB. Belichtete und entwickelte Platten werden bei 140 °C während einer Stunde zusätzlich gehärtet. Der Gitterschnittest ergibt Gt0, Bleistifthärte 3H, Beständigkeit in Methylenchlorid >1 h und Lötbadbeständigkeit >10 Sekunden.

Beispiel 9: Eine Lösung bestehend aus 22,6 g Lösung aus Beispiel 4 (11,3 g Feststoff), 3,96 g Scripset® 550 (teilweise verestertes Copolymeres auf Basis von Styrol und Maleinsäure der Fa. Monsanto), 3,96 g Scripset® 540 (teilweise verestertes Copolymeres auf Basis von Styrol und Maleinsäure der Fa. Monsanto), 8,6 g Gemisch von verschiedenen Acrylsäureestern (2,3 g Tetraethylenglykoldimethacrylat, 2,1 g Trimethylolpropantriacrylat, 2,5 g Pentaerythritoltriacrylat und 1,7 g ethoxyliertes Trimethylolpropantriacrylat), 7 g Talkum Ultramix, 0,21 g Farbstoff (Orasolblau GN; CIBA-GEIGY), 1,6 g 2-Methyl-1-[4-(methylthio)phenyl]-2-morpholino-propan-1-on, 7,0 g O,O′-[Methylen-bis-(1,4-phenyleniminocarbonyl)]-dioxim-butan-2-on, 0,21 g 4,4′-Bis-(diethylamino)-benzophenon und 0,2 g FC-430 (3M-Company) in 44,6 g Ethylglykoletheracetat wird mit einem Rakelbeschichtungsgerät auf eine Leiterplatte aufgebracht. Der Film wird für 15 Minuten bei 80 °C getrocknet. Es resultiert eine Schichtdicke von ungefähr 30 »m. Die so erhaltene Schicht wird durch eine Maske für 15 Sekunden mit einer Quecksilberhochdrucklampe belichtet (Abstand vom Probentisch 50 cm). Die belichtete Probe wird mit einer 1 %igen Natriumcarbonatlösung entwickelt. Die belichtete und entwickelte Platte hatte einen Gitterschnitt von Gt0 (DIN 53151) und die Bleistifthärte beträgt HB. Belichtete und entwickelte Platten werden bei 140 °C während einer Stunde zusätzlich gehärtet. Der Gitterschnittest ergibt Gt0, Bleistifthärte 3H, Beständigkeit in Methylenchlorid >1 h und Lötbadbeständigkeit >1 Minute.

## Patentansprüche

1. Photohärtbare und lösungsmittelentwickelbare Zusammensetzung enthaltend
a) ein photopolymerisierbares Acrylat- oder Methacrylat,
b) einen Photoinitiator für Komponente a),
c) ein polymeres organisches Bindemittel enthaltend freie Carboxylgruppen, welches eine Säurezahl von mindestens 60 aufweist,
d) als Vernetzungsmittel ein blockiertes Polyisocyanat, das eine Aufspalttemperatur von mindestens 100°C besitzt, und
e) ein inertes Lösungsmittel in einer solchen Menge, dass die photohärtbare Zusammensetzung giessfähig ist.

2. Zusammensetzung gemäss Anspruch 1, dadurch gekennzeichnet, dass Komponente a) eine Verbindung der Formel II ist
A-R₃-(A)ₙ (II),
worin n 2,3 oder 4 bedeutet, R₃ der Rest eines aliphatischen oder cycloaliphatischen n-wertigen Alkohols nach dem Entfernen der funktionellen Gruppen ist und A ein Rest der Formel I ist, 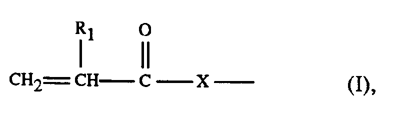 worin R₁ Wasserstoff oder Methyl bedeutet und X -O- ist.

3. Zusammensetzung gemäss Anspruch 1, dadurch gekennzeichnet, dass Komponente a) neben den Acrylat- und/oder der Methacrylatgruppen noch zusätzliche funktionelle gegenüber Isocyanaten reaktive Reste enthält, insbesondere freie Carboxylgruppen oder Alkoholgruppen.

4. Zusammensetzung gemäss Anspruch 1, dadurch gekennzeichnet, dass Komponente b) ausgewählt wird aus der Gruppe bestehend aus Benzoin, Benzoinalkylethern, α-substituierten Acetophenonen, insbesondere α-halogensubstituierten Acetophenonen, α-amino-substituierten Acetophenonen, Dialkoxyacetophenonen oder α-Hydroxyacetophenonen; Benzophenonen, Titanoceninitiatoren, Stannanen in Kombination mit photoreduzierbaren Farbstoffen; Chinonen oder Thioxanthonen in Kombination mit Aminen, die an einem α-C-Atom mindestens ein Wasserstoffatom aufweisen; Thioxanthonen und Acylphosphinoxiden.

5. Alkalisch-wässrig entwickelbare Zusammensetzung gemäss Anspruch 1, dadurch gekennzeichnet, dass Komponente c) als solche in einem alkalisch-wässrigen Lösungsmittel löslich ist.

6. Alkalisch-wässrig entwickelbare Zusammensetzung gemäss Anspruch 5, dadurch gekennzeichnet, dass Komponente c) ausgewählt wird aus der Gruppen bestehend aus Homopolymeren auf der Basis von Acrylsäure, Methacrylsäure, Maleinsäure oder Itaconsäure, und Copolymeren auf der Basis von Acrylsäure, Methacrylsäure, Maleinsäure oder Itaconsäure und Styrol oder Estern dieser Säuren, insbesondere deren Alkylestern.

7. Zusammensetzungen gemäss Anspruch 1, dadurch gekennzeichnet, dass Komponente c) ein polymeres organisches Bindemittel enthaltend freie Carboxylgruppen und Acryl- oder Methacrylgruppen im gleichen Molekül ist.

8. Zusammensetzung gemäss Anspruch 1, dadurch gekennzeichnet, dass Komponente d) eine aliphatische, cycloaliphatische, aromatische oder araliphatische Di-, Tri- oder Tetraisocyanatverbindung ist, deren Isocyanatgruppen mit β-Dicarbonylverbindungen, Hydroxamsäureestern, Triazolen, Imidazolen, Imidazoliden, Tetrahydropyrimidinen, Lactamen, Oximen, Hydroxyimiden, Phenolen oder Thiophenolen verkappt sind.

9. Zusammensetzung gemäss Anspruch 1, dadurch gekennzeichnet, dass Komponenten d) eine Aufspalttemperatur zwischen 100 und 160°C besitzt und ein mit Oximen blockiertes Polyisocyanat, insbesondere ein Diisocyanat, ist.

10. Verfahren zur Herstellung von Reliefstrukturen umfassend die Schritte:
i) Aufbringen einer Zusammensetzung gemäss Anspruch 1 auf eine Substratoberfläche,
ii) Trocknen des beschichteten Substrates durch Verdampfen der wesentlichen Anteile des Lösungsmittels e), vorzugsweise durch Erhitzen des beschichteten Substrates, so dass das Lösungsmittel e) im wesentlichen entfernt wird und eine klebfreie Oberfläche entsteht,
iii) bildmässiges Bestrahlen der photoempfindlichen Schicht mit aktinischer Strahlung, so dass die bestrahlten Bereiche der Schicht photopolymerisieren und gegenüber den nicht bestrahlten Bereichen der Schicht weniger löslich werden,
iv) Entfernen der nicht bestrahlten Bereiche der Schicht durch Behandlung der Schicht mit einem Lösungsmittel für die erfindungsgemässe Zusammensetzung, vorzugsweise mit einem alkalisch-wässrigen Entwickler,
v) Erhitzen der entwickelten Schicht auf Temperaturen oberhalb der Aufspalttemperatur des verkappten Polyisocyanats d), um die bestrahlte Zusammensetzung durch und durch zu vernetzen.

11. Verwendung der Zusammensetzungen gemäss Anspruch 1 zur Herstellung von photostrukturierbaren Lötstoppresists und Permanentresists.

## Claims

1. A photocurable and solvent-developable composition comprising
a) a photopolymerizable acrylate or methacrylate,
b) a photoinitiator for component a),
c) a polymeric organic binder which contains free carboxyl groups and has an acid number of at least 60,
d) as crosslinking agent, a blocked polyisocyanate which has a cleavage temperature of at least 100°C, and
e) an inert solvent in an amount such that the photocurable composition is pourable.

2. A composition according to claim 1, wherein component a) is a compound of the formula II
A-R₃-(A)ₙ (II)
in which n is 2, 3 or 4, R₃ is the radical of an aliphatic or cycloaliphatic n-hydric alcohol after removal of the functional groups, and A is a radical of the formula I 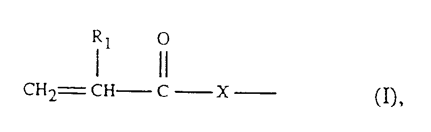 in which R₁ is hydrogen or methyl, and X is -O-.

3. A composition according to claim 1, wherein, besides the acrylate and/or methacrylate groups, component a)additionally contains functional radicals which are reactive towards isocyanates, in particular free carboxyl groups or alcohol groups.

4. A composition according to claim 1, wherein component b) is selected from the group comprising benzoin, benzoin alkyl ethers, α-substituted acetophenones, in particular α-halogenated acetophenones, α-amino-substituted acetophenones, dialkoxyacetophenones or α-hydroxyacetophenones; benzophenones, titanocene initiators, stannanes in combination with photoreducible dyes; quinones or thioxanthones in combination with amines which have at least one hydrogen atom on an α-C atom; thioxanthones and acylphosphine oxides.

5. A composition according to claim 1 which can be developed in alkaline aqueous media, wherein component c) is soluble as such in an alkaline aqueous solvent.

6. A composition according to claim 5 which can be developed in alkaline aqueous media, wherein component c) is selected from the groups comprising the homopolymers based on acrylic acid, methacrylic acid, maleic acid or itaconic acid, and copolymers based on acrylic acid, methacrylic acid, maleic acid or itaconic acid and styrene or esters of these acids, in particular the alkyl esters thereof.

7. A composition according to claim 1, wherein component c) is a polymeric organic binder containing free carboxyl groups and acrylic or methacrylic groups in the same molecule.

8. A composition according to claim 1, wherein component d) is an aliphatic, cycloaliphatic, aromatic or araliphatic di-, tri- or tetraisocyanate compound whose isocyanate groups are blocked by β-dicarbonyl compounds, hydroxamates, triazoles, imidazoles, imidazolides, tetrahydropyrimidines, lactams, oximes, hydroxyimides, phenols or thiophenols.

9. A composition according to claim 1, wherein component d) has a cleavage temperature between 100 and 160°C and is an oxime-blocked polyisocyanate, in particular a diisocyanate.

10. A process for the production of relief structures comprising the steps:
i) application of a composition according to claim 1 to a substrate surface,
ii) drying of the coated substrate by evaporation of the majority of the solvent e), preferably by heating the coated substrate, so that the solvent e) is substantially removed and a tack-free surface is produced,
iii) image-wise irradiation of the photosensitive coating with actinic radiation, so that the irradiated areas of the coating photopolymerize and become less soluble than the non-irradiated areas of the coating,
iv) removal of the non-irradiated areas of the coating by treating the coating with a solvent for the composition according to the invention, preferably with an alkaline aqueous developer,
v) heating the developed coating to temperatures above the cleavage temperature of the blocked polyisocyanate d) in order to thoroughly crosslink the irradiated composition.

11. The use of a composition according to claim 1 for the preparation of photostructurable solder resists or permanent resists.

## Revendications

1. Composition photodurcissable et développable avec un solvant, contenant
a) un acrylate ou un méthacrylate photopolymérisable,
b) un photoamorceur pour le constituant a),
c) un liant organique polymère contenant des groupes carboxy libres, qui présente un indice d'acide d'au moins 60,
d) un polyisocyanate bloqué ayant une température de dissociation d'au moins 100°C comme agent de réticulation, et
e) un solvant inerte en une quantité telle que la composition photodurcissable puisse couler.

2. Composition selon la revendication 1, caractérisée en ce que le constituant a) est un composé de formule II
A-R₃-(A)ₙ (II),
dans laquelle n représente 2, 3 ou 4, R₃ est le reste d'un alcool aliphatique ou cycloaliphatique à n fonctions alcool après l'élimination des groupes fonctionnels et A est un reste de formule I 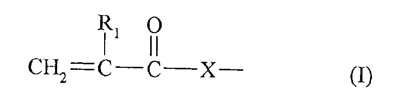 dans laquelle R₁ représente un hydrogène ou un méthyle et X est -O-.

3. Composition selon la revendication 1, caractérisée en ce que le constituant a) contient, en plus des groupes acrylate et/ou méthacrylate, d'autres restes fonctionnels réactifs vis-à-vis des isocyanates, en particulier des groupes carboxy libres ou des groupes alcool.

4. Composition selon la revendication 1, caractérisée en ce que le constituant b) est choisi dans le groupe constitué par la benzoïne, des éthers alkyliques de benzoïne, des acétophénones substituées en α, en particulier des acétophénones halogénées en α, des acétophénones substituées en α par amino, des dialcoxyacétophénones ou des α-hydroxyacétophénones; des benzophénones, des amorceurs de type titanocène, des stannanes en combinaison avec des colorants photoréductibles; des quinones ou des thioxanthones en combinaison avec des amines ayant au moins un atome d'hydrogène sur un atome de carbone en α; des thioxanthones ou des oxydes d'acylphosphines.

5. Composition développable en milieu aqueux alcalin selon la revendication 1, caractérisée en ce que le constituant c) est soluble tel quel dans un solvant aqueux alcalin.

6. Composition développable en milieu aqueux alcalin selon la revendication 5, caractérisée en ce que le constituant c) est choisi dans le groupe constitué par des homopolymères à base d'acide acrylique, d'acide méthacrylique, d'acide maléique ou d'acide itaconique et des copolymères à base d'acide acrylique, d'acide méthacrylique, d'acide maléique ou d'acide itaconique et de styrène ou d'esters de ces acides, en particulier de leurs esters alkyliques.

7. Compositions selon la revendication 1, caractérisées en ce que le constituant c) est un liant organique polymère contenant des groupes carboxy libres et des groupes acryliques ou méthacryliques dans la même molécule.

8. Composition selon la revendication 1, caractérisée en ce que le constituant d) est un composé de di-, tri- ou tétraisocyanate aliphatique, cycloaliphatique, aromatique ou araliphatique, dont les groupes isocyanate sont bloqués avec des composés β-dicarbonylés, des esters d'acides hydroxamiques, des triazoles, des imidazoles, des imidazolides, des tétrahydropyrimidines, des lactames, des oximes, des hydroximides, des phénols ou des thiophénols.

9. Composition selon la revendication 1, caractérisée en ce que le constituant d) a une température de dissociation comprise entre 100 et 160°C et est un polyisocyanate, en particulier un diisocyanate, bloqué avec des oximes.

10. Procédé de préparation de structures en relief comprenant les étapes selon lesquelles:
i) on applique la composition selon l'invention sur la surface d'un substrat,
ii) on sèche le substrat revêtu par évaporation des fractions essentielles du solvant e), de préférence par chauffage du substrat revêtu, de façon à éliminer essentiellement le solvant e) et à former une surface non collante,
iii) on expose suivant une image la couche photosensible à un rayonnement actinique de façon à photopolymériser les zones exposées de la couche et à les rendre moins solubles que les zones non exposées de la couche,
iv) on élimine les zones non exposées de la couche en traitant la couche avec un solvant pour la composition selon l'invention, de préférence avec un révélateur aqueux alcalin,
v) on chauffe la couche développée à des températures supérieures à la température de dissociation du polyisocyanate bloqué d) pour réticuler entièrement la composition exposée.

11. Utilisation des compositions selon la revendication 1 pour la préparation de résists de brasage et de résists permanents qui se structurent sous l'effet d'un rayonnement.
